# EUROPEAN PATENT APPLICATION

(11) **EP 1 519 421 A1**
(43) Date of publication of application: **30.03.2005**
(21) Application number: 03447238.1
(22) Date of filing: 25.09.2003
(51) Int. Cl.: H01L 29/786, H01L 21/336, H01L 29/423

(54) **Multiple gate semiconductor device and method for forming same**

(71) Applicant: INTERUNIVERSITAIR MICROELEKTRONICA CENTRUM VZW, 3001 Leuven (BE)
(72) Inventor: Dixit, Abhisek, 3001 Leuven (BE); De Meyer, Kristin, 3020 Herent (BE)
(74) Representative: Van Malderen, Joelle

(57) **Abstract**

A multi-gate device in accordance with an embodiment of the present invention comprises at least two gates. The dopant distribution in the semiconductor body of the device varies from a low value near the surface of the body towards a higher value inside the body of the device.

## Description

### Field of the invention

The present invention is related to integrated circuits and methods for manufacturing such integrated circuits. More particularly, the present invention relates to semiconductor devices with multiple gates and non-uniform doping profiles in the channel region of those devices.

### Background of the invention

Current state-of-the-art semiconductor chips feature technology with circuit feature sizes of 180 nanometers, with components manufactured with technologies having 130 nanometer feature sizes just beginning to reach the marketplace. Industry plans are to deliver 90 nanometer technologies in the year 2004, 65 nanometers in the year 2007, 45 nanometers in the year 2010, 32 nanometers in the year 2013 and 22 nanometers in the year 2016. This schedule was set forward in the International Technology Roadmap for Semiconductors (ITRS) defined by the Semiconductor Industry Association (SIA) in 2001. The schedule translates to smaller chip dimensions earlier in time than had been previously thought. Among the main transistor scaling issues to be solved is the need for thinner gate oxides that result in a higher on-current and hence increased switching speed in semiconductor devices, a smaller off-current and lower threshold voltage to allow such gate oxide scaling, and the use of lower supply voltages, a higher channel mobility and smaller series resistance of the source/drain regions. In order to meet these forecasted stringent scaling requirements, non-classical CMOS (Complementary Metal-Oxide-Semiconductor) devices and novel materials, such as metal gate materials and high-k gate dielectrics are currently under investigation.

One of these non-classical CMOS devices is a so-called FinFET transistor. In a FinFET, the gate at least partially envelops the channel region, contrary to the classic planar device where the gate electrode is formed in one plane on top of the channel region, where the channel region is part of the substrate. Such substrates further comprise the source and drain regions adjacent to the channel region. The idea of making a double gate transistor by using the sidewalls of a dry-etched silicon (Si) fin as conducting channels was published in 1998 by D. Hisamoto et al. in "A folded-channel MOSFET for deep-sub-tenth Micron Era" in the IEDM Technical Digest 1998 pp 1032-1034. In a FinFET, a thin gate line straddles a thin silicon channel fin. Bin Yu et al, discusses in "FinFET scaling to 10nm Gate Length" IEDM Technical Digest 8-11 December, 2002 pp 251-254 an alternative process to manufacture a FinFET device. Polysilicon was used as a gate electrode material and the channel of the device was lightly doped.

Although a FinFET can be manufactured in a near-planar, CMOS compatible way, various issues have to be addressed in order to improve the performance of such FinFET over its planar CMOS counterpart. This respective performance of such devices is indicated by various parameters such as the sub-threshold swing (S, mV/dec), which is the variation of drive current with gate voltage for gate voltages below the threshold voltage (Vₜ), the maximum or saturation drive current (Iₒₙ), the off state-current or leakage current I_{off}), the threshold voltage roll-off (ΔVₜ) expressing the dependency of the threshold voltage on channel length (L_{g}) and drain voltage (V_{ds}) .

Two approaches are currently being employed to improve the FinFET device parameters. A first approach is to increase the dopant level (N_{fin}) of the fin. Although this approach yields a low sub-threshold slope and a controllable threshold voltage, as inversion will occur near the surface of the fin, the carrier mobility is degraded due to ionized impurity scattering. This scattering results in a lower saturation current, which slows down the device. Also the threshold voltage roll-off will be more pronounced, as the highly doped fin will not be fully depleted.

A second approach involves lowering the fin doping and developing a tunable work-function gate technology. Yang-Kyu Choi et al in "FinFET Process Refinements for Improved Mobility and Gate Work Function Engineering" in IEDM 2002 Digest outline this approach. International, 8-11 Dec, 2002, p 259-262. Apart from forming a high quality interface between the fin and the gate dielectric, the mobility of the carriers can be improved by lowly doping the fin resulting in less ionized impurity scattering and hence in a larger saturation current. A lowly doped fin also offers the advantage of increasing the immunity of the threshold voltage to fluctuations in the dopant distribution profile. However, because of the low doping of the fin, the threshold voltage is determined by the work function of the gate electrode, which must then be carefully selected in order to obtain the desired threshold voltage for either n-type or p-type FinFETs. This approach is also cumbersome, as only a limited selection of materials is available, thereby still requiring additional efforts to tune the work function of these materials to the desired value. The introduction of such materials adds to the manufacturing process complexity. The low doping of the fin also results in a higher sub-threshold slope and consequently in a larger leakage current and a larger power consumption as is disclosed in "A Comprehensive Model Analytical Sub-threshold Swing (S) Model for Double-gate MOSFETs" by Qiang Chen et al, in IEEE Transactions on Electronic Devices, Vol. 49, No. 6, June 2002, p 1086.

Therefore an aim of the present invention is to overcome the problems of the prior art and to achieve improved performance of a FinFET. Another aim of the present invention is to tune the threshold voltage of the FinFET without degrading other device parameters such as sub-threshold slope, saturation current, leakage current and threshold voltage roll-off.

### Summary of the invention

In a first aspect of the invention a multi-gate semiconductor device is disclosed comprising a source region and a drain region, a semiconductor body in-between which connects the source region and the drain region, a gate electrode at least at two sides of said body, wherein the semiconductor body comprises a first region having a first dopant level and a second region in-between the gate electrode and the first region, this second region having a second dopant level lower than the first doping level. This multi-gate semiconductor device may comprise a FinFET device wherein the body is the fin of the FinFET device. In certain embodiments, the first dopant level remains constant over the first region. In another embodiment, the second dopant level remains constant over the second region. In another embodiment, the dopant concentration in the second region decreases from the first dopant level to the second dopant level within the second region.

In a second aspect of the invention a method is disclosed for manufacturing a retrograde doped multigate device according to the first aspect of the invention. In an exemplary embodiment a method for manufacturing a FinFET according to the present invention is disclosed. This method comprises providing a substrate, the substrate comprising a source, a drain and a fin connecting said source and said drain, said fin having a first dopant level, and forming a layer, at least at the exposed surfaces of the fin, said layer having a dopant level lower than said first dopant level.

These as well as other aspects and advantages will become apparent to those of ordinary skill in the art by reading the following detailed description, with appropriate reference to the accompanying drawings.

### Description of figures.

The appended drawings are intended to illustrate some aspects and embodiments of the present invention. Devices in the drawings are depicted in a simplified way for reason of clarity. Not all alternatives and options are shown and, therefore, the invention is not limited in scope by the drawings. It is noted that like reference numerals are employed to reference analogous parts of the various drawings, in which:

Figure 1 shows (a) a isometric view of a prior art FinFET device formed in an SOI layer and (b) a cross-section A-A of the fin along the gate.

Figure 2 shows a schematic cross section (b) of a dual gate illustrating the lowly doped and highly doped regions while (a) shows the dopant profile along line B-B.

Figure 3 shows a schematic cross section (b) of a triple gate semiconductor device illustrating the lowly doped and highly doped regions while (a) shows the dopant profile along line B-B and (c) shows the dopant profile along line C-C.

Figure 4 shows a comparison between 3 alternative FinFET devices, each having a threshold voltage of 100mV the devices having (i) uniform doping of the fin, (ii) retrograde doping according to the present invention (according to the profile shown in Figure 4a), and (iii) work function engineering of the gate electrode material wherein (b) shows saturation current (linear scale) (c) shows saturation current (logarithmic scale) and (d) shows sub-threshold swing.

Figure 5 shows a doping profile in the fin of a FinFET according to an embodiment of the invention.

Figure 6 shows an alternative FinFET device according to an embodiment of the invention, wherein the device is illustrated in schematic cross-sections (a) showing a patterned fin with higher doped body, (b) showing the formation of the lowly doped surface layer enveloping at least the higher doped body of the device, (c) showing the doping of the source and drain while using the gate as a mask to protecting the channel (s) from the implantation, and (d) showing a cross-section A-A of the device.

### Detailed description

In relation to the drawings, the present invention is described in detail in the following detailed description. It will be apparent, however, to a person skilled in the art that numerous other equivalent embodiments or other ways of practicing the present invention exist.

In a first aspect of the invention, a semiconductor device comprising at least two gates is disclosed. The body of this semiconductor device (e.g., the volume between these two gates) is non-uniformly doped. From the interface between the body and each gate towards the bulk of the body, the dopant concentration varies from a low value to a higher value. In his article "Beyond the Conventional Transistor", published in IBM Journal of Research & Development, Vol. 46, No. 23 2002, H.-S. Wong discloses various types of multi-gate devices. In figure 14, 15 and 17 of this paper, alternative orientations of such a double or triple gate device are depicted with the corresponding process sequences being detailed in pages 146 to 152. This paper is hereby incorporated by reference in its entirety. For the purpose of teaching the invention, a FinFET device will be used to illustrate the various embodiments of the invention. However, the present invention is not limited to this type of multi-gate device.

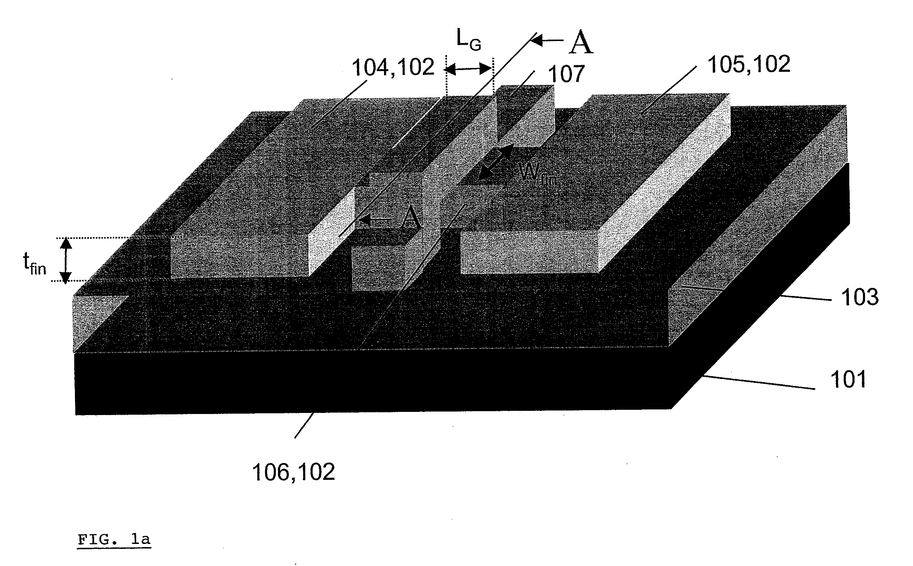

Figure 1a shows a prior art FinFET device. In a semiconductor layer (102) on a substrate (101) a FinFET device, and optionally other semiconductor devices, is formed. The substrate itself can be a semiconductor substrate, e.g. silicon. An insulating layer (103) can be formed on top of this substrate (101) to insulate the semiconductor layer (102) from the substrate (101). This way e.g. a silicon-on-insulator (SOI) or a germanium-on-insulator (GeOI) substrate is formed. The FinFET device as shown in figure 1a comprises a source (104) and a drain (105) region connected by a fin (106), located in between this source and drain region. The fin (106) will constitute the body of this multi-gate device. Depending on the process flow, the three elements (104, 105, 106) can be formed in a single layer of semiconductor material or in different layers of this semiconductor material. A gate (107), comprising a gate dielectric and a gate electrode layer, is formed as to overly the fin (106) at three sides: the top surface and the two sides. A channel of the FinFET will be that part of the fin (106) which is covered by and, depending on the thickness of the gate dielectric, under electrical control of the corresponding gate (107).

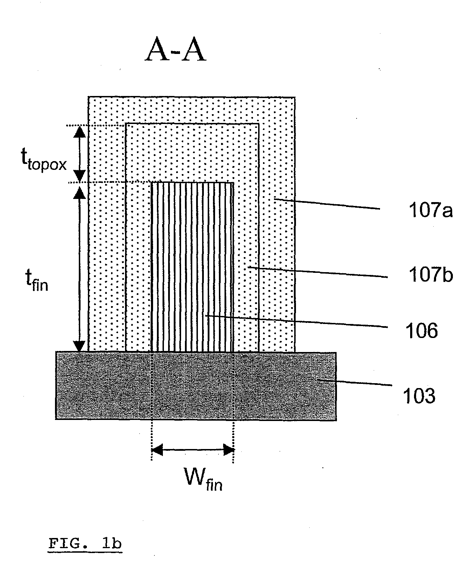

A cross-section along the gate (107) of the FinFET shown in figure 1a is given in figure 1b, illustrating the surrounding of the fin (106) at both sidewalls as well on the top by the gate (107), comprising a gate dielectric (107a) and a gate electrode layer (107b). In case of a thick gate dielectric (tₜₒₚₒₓ) on top of the fin, a double gate is obtained in which inversion occurs along the upstanding sidewalls of the fin (shown in figure 1b), while for a thin top gate dielectric inversion of the top channel can also occur in the top surface of the fin. Methods for forming FinFET devices are known in the art. An example is disclosed in "High-Performance Symmetric-Gate and CMOS Compatible Vₜ Asymmetric-Gate FinFET devices" in IEDM Technical Digest 2001 pp 437-440, by J. Kedzierski et al. wherein the source/drain regions or pads, as they are labeled there, are formed together with the fin channel in the SOI layer using optical lithography and a hard mask trimming technique.

To achieve optimum performance from the device, the threshold voltage must be adjusted such that other device parameters, saturation current, leakage current, sub-threshold slope, threshold voltage roll-off are not degraded. Exemplary embodiments of the present invention propose to form a retrograde doped channel. With retrograde is meant that the doping of the fin is low at the surface of the fin, but increases towards the bulk of the fin. This way a high surface mobility of the carriers can be obtained because ionized impurity scattering is reduced, while the higher bulk concentration offers a way to tune the threshold voltage of the device. In this respect, polysilicon can still be used as gate material (107) as was the case for the classical MOS device, but also novel gate materials, such as metals, can be used. In the latter case, the bulk doping offers an additional degree of freedom for obtaining the desired threshold voltage next to the tuning of the work function of the gate electrode material.

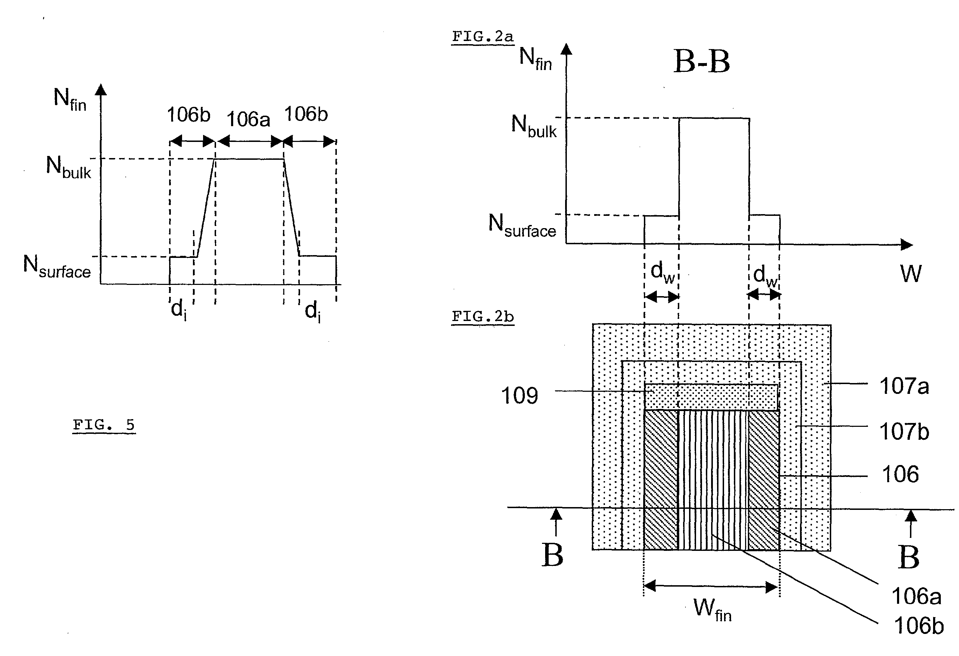

Figure 2 shows, for a schematic cross-section of the FinFET along line A-A (figure 2b), an example of such retrograde doping profile (figure 2a). In this example, the surface dopant level has a constant value N_{surface} over a depth d_{w} into the fin and a higher constant value N_{bulk} in the bulk of the fin over a distance W_{fin}-2 d_{w}. In case of a double gate FinFET, it might be sufficient to only have a dopant gradient in the fin along the horizontal direction. As shown in figure 2b, there exists a lowly doped region (106a) near the interface between the fin (106) and the gate dielectric (107b) along each of the sidewalls of the fin. In this example, the dopant concentration remains constant in a vertical direction, i.e., perpendicular to the substrate (101). Optionally a layer (109) is present on the top of the fin (106), which layer is used to prevent formation of the lowly doped region (106a) at the top of fin (106).

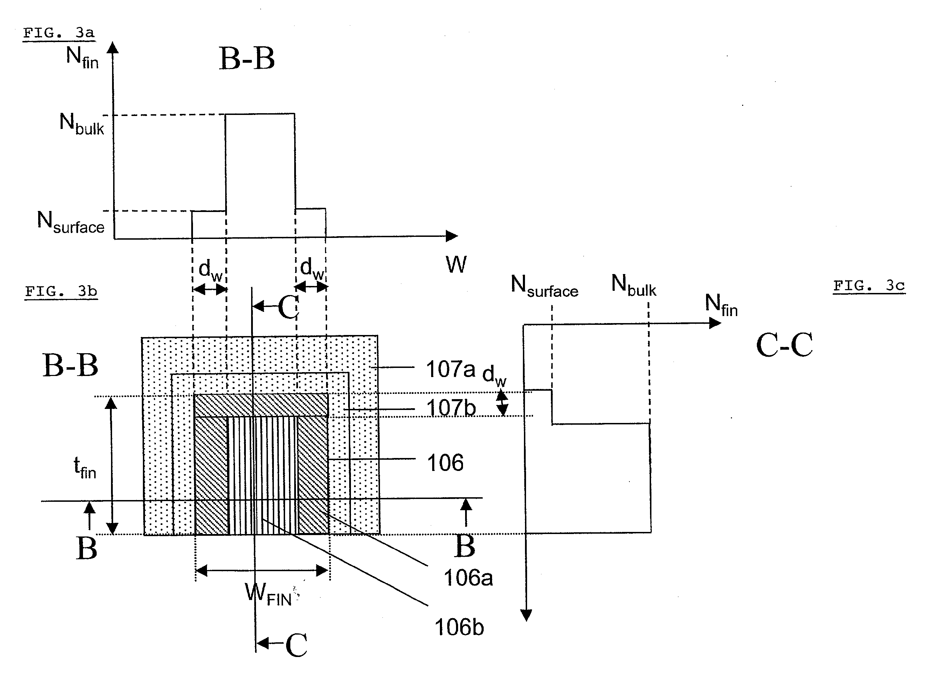

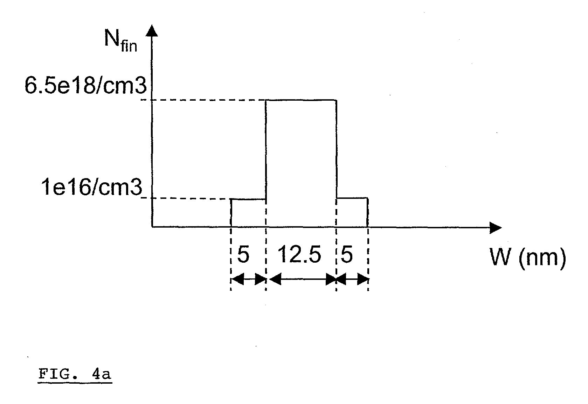

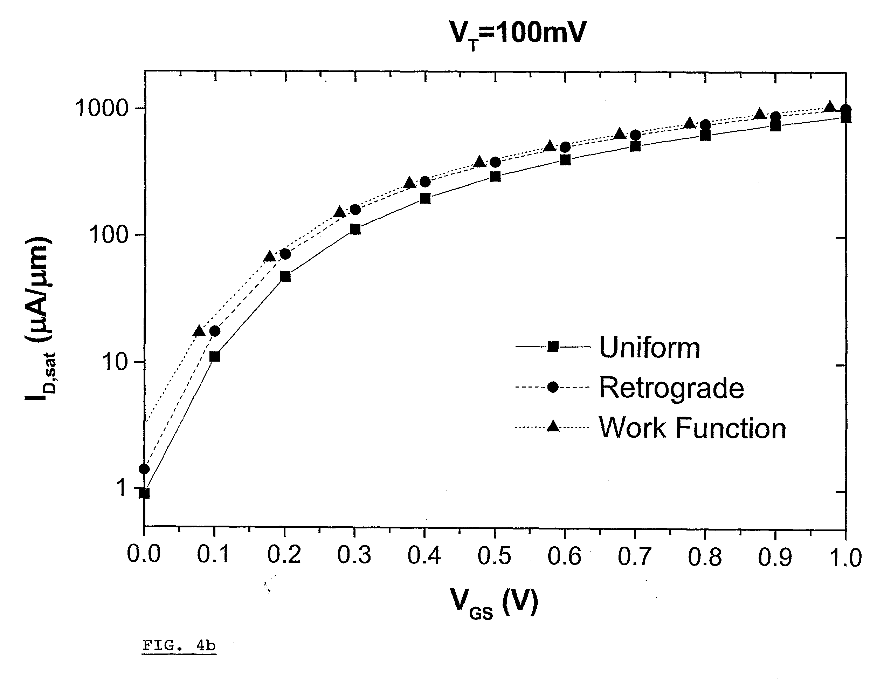

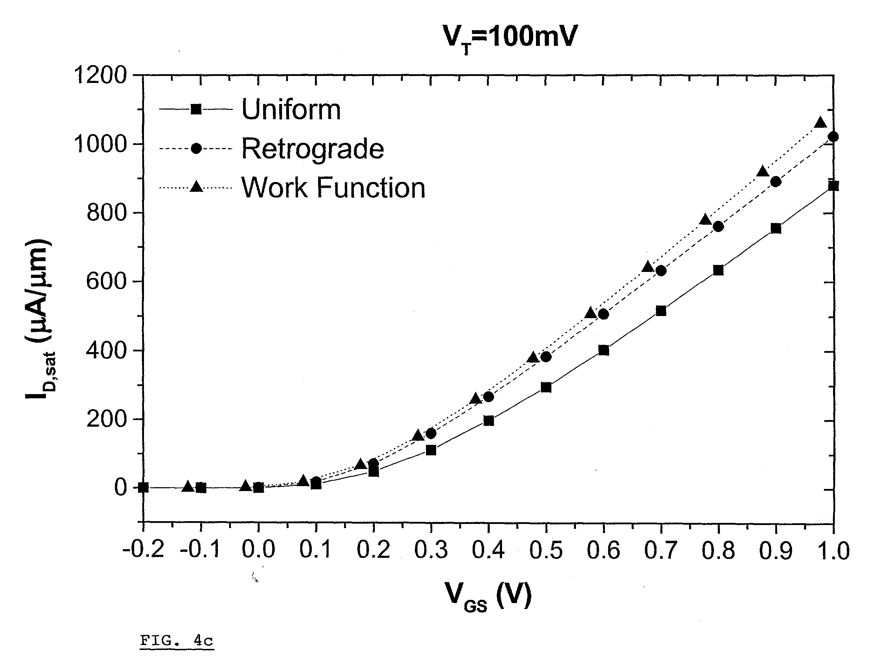

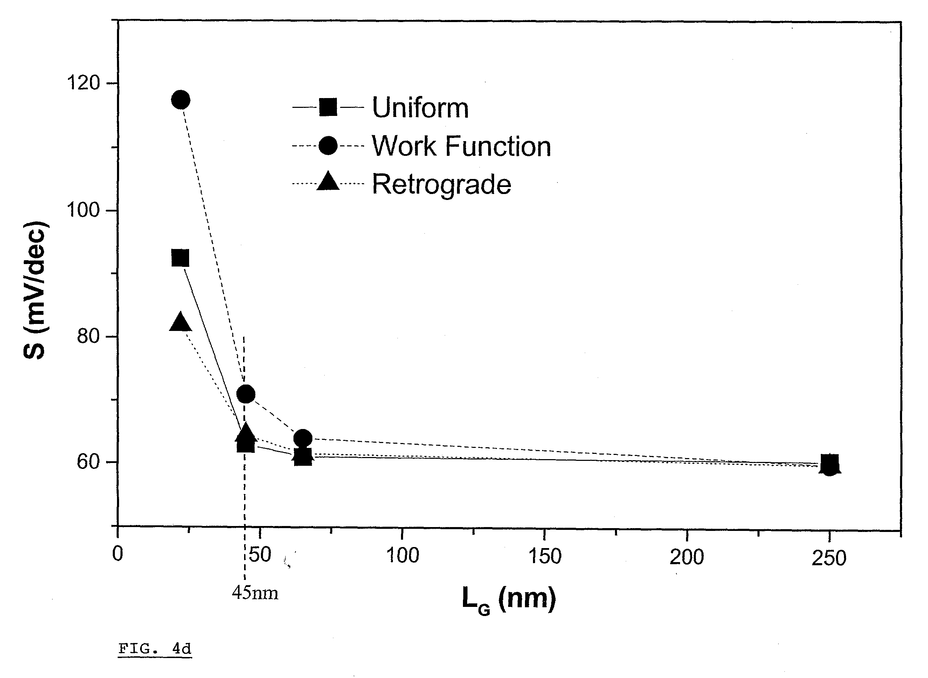

In case a triple gate FinFET is formed, i.e. by having a thin dielectric on top of the fin, then preferably also a dopant gradient is formed in the vertical direction. Figure 3b shows a schematic cross-section of such a triple gate FinFET device. Figure 3a shows the dopant profile in horizontal direction along the section B-B. This profile is similar to the dopant profile given in figure 2a. In a triple gate device, conduction will not only occur along the sidewalls of the fin, but also at the top surface of the fin parallel with the substrate (101). Figure 3c shows the dopant profile in the fin along the line C-C. From the interface between the fin and the gate dielectric, a lowly doped region (106a) is present along a depth d_{w} having a low concentration N_{surface} and a higher constant value N_{bulk} in the bulk of the fin over a distance t_{fin}-2d_{w}. Figures 4 a-d illustrate the advantages of the invention over the prior art. A FinFET device having a threshold voltage of 100mV is simulated using a uniform doping profile of 3e18 cm⁻³ throughout the fin using work function engineering, i.e. selecting the appropriate gate material (107a) and using a retrograde dopant profile as shown in figure 4a. Figure 4b shows on a logarithmic scale the saturation current as function of the gate voltage. At zero gate voltage, the leakage current in saturation region for each alternative can be seen. The "work function" alternative has the largest leakage current, while the "retrograde profile" performs as well as the "uniform profile". Figure 4c shows the saturation current as function of the gate voltage. At maximum gate voltage the drive current for each alternative can be seen. The "uniform profile" alternative has the lowest drive current, while the "retrograde profile" performs as well as the "work function" alternative. In figure 4d the sub-threshold swing as function of the gate length Lg is given for the three approaches. For a gate length of 45 nm, which is the device used in figure 4b and 4c, having a threshold voltage of 100 mV, the sub-threshold swing of the "retrograde profile" is as low as the sub-threshold swing of the "uniform profile", but with decreasing gate length the sub-threshold swing of the "retrograde profile" becomes the smallest of all three approaches, indicating it is more useable in down scaling devices.

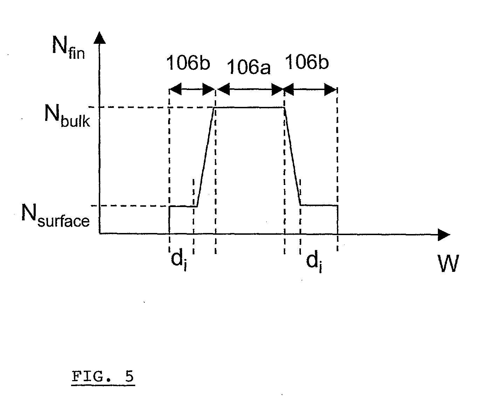

Whereas in figures 2a, 3a and 3c a box-like profile is shown, other profiles can be envisaged within the scope of this invention. One could use a profile with a central portion (106b) of the fin having a first constant doping level, and a outer portion (106b) of the fin wherein the doping level decreases to a second doping level, being less than the first doping level. Within this border region (106b), the doping level can decrease in various ways: linear, exponential, etc. The doping level can vary between the two values, first and second doping level over the complete width d_{w} of this region (106b). In a preferred embodiment, illustrated in figure 5, the doping concentration decreases from the first doping level at the border of the central portion (106a) to the second doping level within the outer region (106b) from whereon it will remain constant until the edge of the fin is reached. As during operation charge carriers will flow mainly in this constant portion of region (106b) the carriers will be less prone to impurity scattering and a larger drive current will be obtained. Preferably the width dᵢ of this constant region corresponds to the width of the inversion layer region. Typically the first doping level will be in the range of 1e18 to 1e20, preferably 1e19 cm⁻³. The second doping level will be in the range of 1e15 to 1e17, preferably 1e16 cm⁻³. The values of the first and second doping level will depend on the threshold voltage that needs to be obtained. In a preferred embodiment of the invention, the first doping level is of the order of 1e19 cm⁻³ and the second doping level is of the order of 1e16 cm⁻³. The fin has a total thickness of about W_{fin} = 45nm, with a central portion (106a) of about 25nm and an outer region (106b) of about d_{w} = 10nm per side. Typically, the inversion layer thickness is less than a few nanometers.

In a second aspect of the invention, methods are disclosed to manufacture such a multi-gate device comprising an increasing dopant profile from each gate on towards the bulk of the device.

In one embodiment of the second aspect layer, deposition techniques are employed to form a layer enveloping the body of the device resulting in a bi-layer structure, each layer, i.e. the body and the enveloping layer, of this belayed structure having a different dopant concentration. This enveloping layer is at least present at these surfaces of the body (106) where conduction is to take place and upon which gates (107) will be formed. Various techniques exist in semiconductor technology to deposit layers. One of these techniques is chemical vapor deposition (CVD), which covers a wide range of processes: epitaxial layer growth, atomic layer CVD, plasma enhanced CVD, all of which are known by a person skilled in the art. Prior to the step of depositing the gate dielectric (106b), a layer (108), preferably a conformal layer is formed, overlying the fin (106) of the device. This layer can be in-situ doped, i.e. dopants are added to the precursors of the gas mixture from which the conformal layer is to be formed. These dopants are then incorporated into the deposited layer (108). Hence the dopant concentration of this deposited layer can be different from the dopant concentration in the initial body or as-patterned fin of the device. On top of this deposited layer the gate dielectric (106b) will be formed and the processing of the FinFET can continue. The layer (108) can be formed uniformly over the wafer or can be formed in a selective way, i.e. only on the exposed surfaces of the fin (106), as the top surface of the fin (106) might optionally by covered with a layer or treated as to not react with the species of the deposition atmosphere. This selective deposition can be obtained by using epitaxial layer growth or selective ALD, both techniques are known by a person skilled in the art. Wolf and Tauber teaches in "silicon processing for the VLSI era, volume I - Process Technology", 2^{nd} Edition, Lattice Press, on page 225-226 the concept of epitaxial growth, on page 236 the concept of in-situ doping such layers (section 7.4.3) and in section 7.7 on page 245-247 the concept of selective epitaxial growth. The published PCT application WO 01/15220 teaches the concept of using atomic layer deposition (ALD) for forming layers on selected surfaces only, hereby incorporated by reference in its enterity. The selectivity can be obtained by using layers with different surface chemistry to form selected surfaces or by pre-treating selected surfaces to block the depositing of a layer on these pre-treated surfaces.

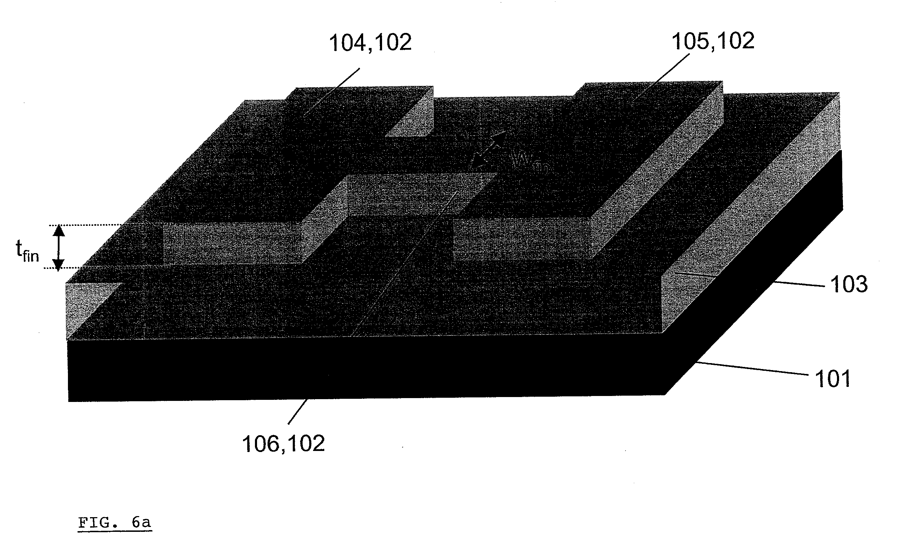

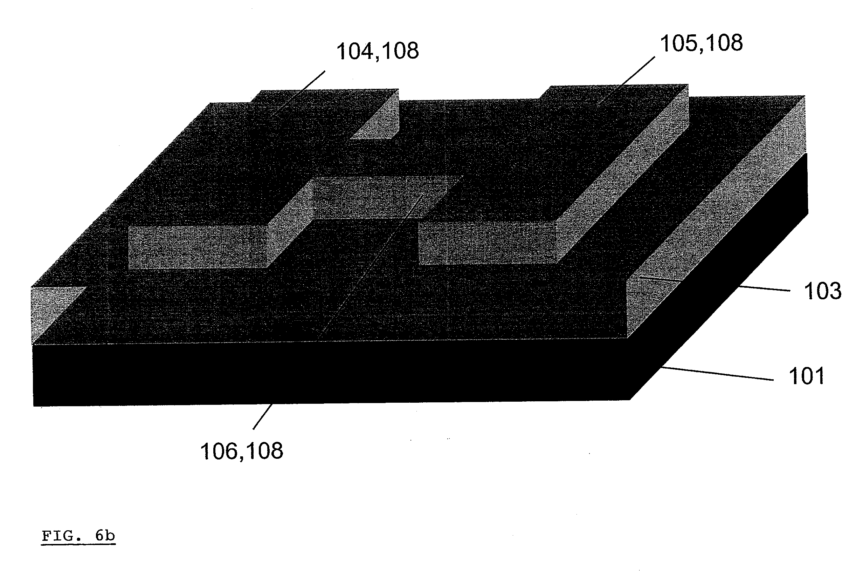

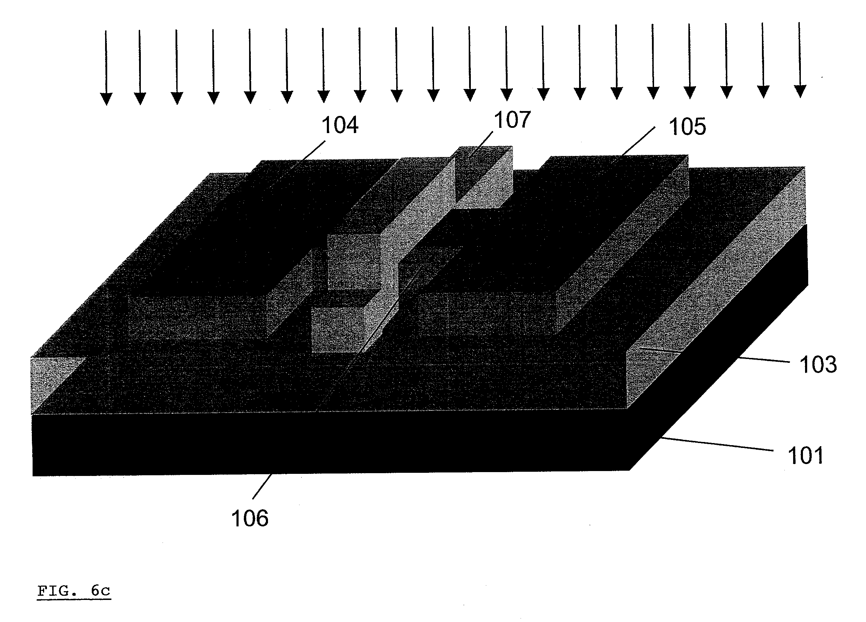

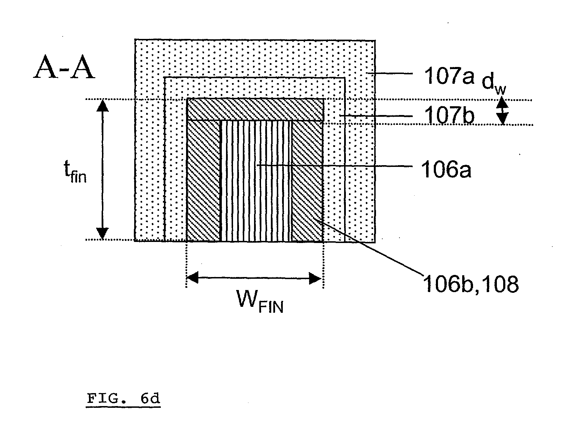

In a preferred embodiment of this second aspect, epitaxial layer growth is used to create a dopant gradient in the body of the device. A process sequence is illustrated in figure 6.

Figure 6a shows the device after patterning the fin (106) having a width W_{fin}. In this example, source (104), drain (105) and fin (106) are patterned in the same semiconductor layer (102), however the invention is not limited thereto. The fin (106) is implanted to a first doping level N_{bulk} selected for the bulk of the body. In an alternative sequence, this N_{bulk} implantation is done prior to the step of patterning the fin (106). This implantation can be done in a masked way, i.e., only implanting the fin (106) or in an unmasked way also implanting the source (104) and drain (105) or the whole of the layer (102) in which source (104), drain (105) and fin (106) are formed. In the latter case, the higher junction doping of the source (104) and drain (105), given afterwards and which is of an opposite type, will compensate this lower N_{bulk} in these source and drain regions. In case electrons are to be used as carriers, the fin will be p-type doped using dopants such as B, BF2, while the source and drain regions will be n-type doped using dopants such as P, As.

Preferably a sacrificial oxide is grown and afterwards removed by a wet etch. This sacrificial oxide will remove all damage, e.g. resulting from the patterning step, at the exposed surfaces of the fin (106). Using epitaxial layer growth, a layer (108) is formed enveloping the fin (106) and the source (104), drain (105) areas as is shown in figure 6b. This layer (108) is in-situ doped to a second dopant level N_{surface}, which is lower than the bulk concentration N_{bulk}. An additional advantage of this embodiment is that the formation of an epitaxial layer on the fin will reduce the roughness of the interface between the fin and the epitaxial layer formed thereon and, hence, improve the performance of the final device even further.

As shown in figure 6c, the gate (107) is formed and source (104), drain (105) regions are implanted. As explained above, that part of the epitaxial layer (108) enveloping the source and drain will be compensated by this counter-doping of the source and drain, while that part of this layer (108) enveloping the fin (106) which corresponds to the channel will remain as-doped as it is masked by the gate (107). Other process steps known to a person skilled in the art are then executed the complete the processing of the device, e.g. forming insulating layers covering the device, forming electrical contacts to contact the terminals (104, 105, 106) of the device etc.

Figure 6d shows the cross-section A-A of the device. The body (106) having a first dopant level is covered at the sidewalls and at this top with a layer (108), having a second dopant level lower than the first dopant level. This bilayer structure is covered by the gate (107), the overlay area between the bilayer structure and the gate (107) defining the channel length Lg.

In case a double gate is to be formed as shown in figure 2b, the above process only need some minor modifications. Prior to the step of forming the layer (108), as illustrated in figure 6b, a blocking layer will be formed on the top of the fin (106). A person skilled in the art will appreciate that this blocking layer is formed over the unpatterned semiconductor layer (102) and subsequently patterned in a region, which corresponds to the top of the fin (106). Afterwards the fin (106) and the source region (104) and drain region (105) are patterned in the semiconductor layer (102) aligned to the patterned blocking layer (109). In an alternative method the blocking layer is deposited uniformly over the unpatterned semiconductor layer (102). Both layers, the blocking layer and the semiconductor layer (102), are patterned during the same patterning step. In this case the patterned blocking layer (109) will coincide with the pattern of the source (104), drain (105) and fin (106) formed in the semiconductor layer (102). As discussed above selective depositing process, such as epitaxial layer growth or atomic layer deposition (ALD) can be applied, in which case layer (108) is only formed on the exposed surfaces of the fin (106), i.e. at the sidewalls, and not on the patterned blocking layer (109) on top of the fin (106).

Exemplary embodiments of the present invention have thus been illustrated and described. It will be understood, however, that changes and modifications may be made to the invention as described without deviating from the spirit and scope of the invention, as defined by the following claims.

## Claims

1. A multi-gate semiconductor device comprising:
- a source region (104) ;
- a drain region (105);
- a semiconductor body (106) in-between said source region (104) and drain region (105), and connecting said source region (104) and said drain region (105); and
- a gate structure (107) formed at at least two sides of said body (106) ;
**characterized in that**
said semiconductor body (106) comprises a first region (106b) having a first dopant level and a second region (106a), in-between said gate structure (107) and said first region (106b), having a second dopant level lower than said first doping level.

2. The device of claim 1 wherein said multi-gate semiconductor device is a FinFET device and said semiconductor body (106) comprises the fin of said FinFET device.

3. The device of claim 1 or 2 wherein said first dopant level remains constant over said first region (106b) .

4. The device of any foregoing claim wherein said second dopant level remains constant over said second region (106a).

5. The device of claim 1, 2 or 3 wherein the dopant concentration in said second region (106b) decreases from said first dopant level to said second dopant level within said second region.

6. A method for manufacturing a retrograde FinFET, comprising:
providing a substrate (101), wherein the substrate comprises:
- a source (104);
- a drain (105); and
- a fin (106) connecting said source (104) and said drain (105), wherein said fin (106) has a first dopant level; and
**characterized in that**
it further comprises forming a layer (108), at least on the exposed surfaces of the fin (106), said layer having a dopant level lower than said first dopant level.

7. A method as claimed in claim 6 wherein the step of forming a layer (108) includes in-situ doping of the layer (108).

8. A method as recited in claim 6 or 7 wherein said said layer (108) is formed using epitaxial layer growth.
